# EUROPEAN PATENT SPECIFICATION

(11) **EP 1 596 435 B1**
(45) Date of publication and mention of the grant of the patent: **18.03.2015**
(21) Application number: 05252795.9
(22) Date of filing: 06.05.2005
(51) Int. Cl.: H01L 23/498, H01L 21/48

(54) **A pattern form object and a manufacturing method thereof**
Ein Muster und Herstellungsverfahren dafür
Un motif et son procédé de fabrication

(30) Priority: 11.05.2004 JP 2004141085
(43) Date of publication of application: 16.11.2005
(73) Proprietor: Ricoh Company, Ltd., Tokyo 143-8555 (JP)
(72) Inventor: Sano, Takeshi, Minamiashigara-shi, Kanagawa (JP); Ohkura, Hideaki, Yokohama-shi, Kanagawa (JP); Kobayashi, Hirofumi, Yamato-shi, Kanagawa (JP)
(74) Representative: Mounteney, Simon James

(56) References cited:
- EP-A- 0 277 325
- WO-A-84/03586
- DE-A1- 3 830 131
- JP-A- 10 051 089
- JP-A- 2000 036 650
- JP-A- 2001 168 485
- US-A- 2 585 700

## Description

### BACKGROUND OF THE INVENTION

### 1. Field of the Invention

The present invention generally relates to a pattern form object, which includes a desired pattern formed on a supporting material, and a manufacturing method thereof. The present invention specifically relates to a pattern form object that includes a circuit pattern formed on a supporting material such as a printed circuit board, a pattern form object that includes a pattern of a color filter of a display, and a manufacturing method thereof. This technology is applicable to printing technology.

### 2. Description of the Related Art

Various printing technologies are available such as screen-stencil and photolithography used when forming wiring on a base such as a printed circuit board and a plastic film connector, and when forming a desired pattern of a color filter for a display and an organic-semiconductor device. Items to be considered when forming a pattern on a substrate or a base material include size precision of the pattern, film thickness, an electro-optical property, and a mechanical characteristic. In addition, there is also a problem of adhesion of the pattern to the substrate.

Recently, a material constituted by nano grains has been developed, since pattern formation with it is simple. Especially, development of ink that uses Ag nano grains as the base is advanced for wiring formation, and simple pattern formation technologies using printing methods of ink jet and others have been proposed. The nano grains are applied to or printed on a substrate, and are dried and hardened such that a pattern is formed on the substrate. Here, since the nano grain itself does not have an adhesion property to the base material, a certain measure to provide sufficient adhesion to the substrate is required.

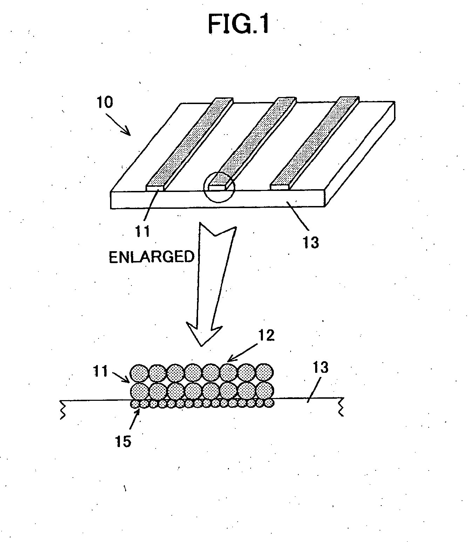

A method of intentionally forming physical bonding, such as the anchor effect, etc., to the base material has been disclosed. The technology is disclosed by JPA 10-51089 (a wiring substrate and its manufacturing method). According to this conventional technology, a conductive component, the main ingredient being low resistance metal powder, is printed on an insulated layer, having needle invasion hardness between 10 and 100 µm; pressure is applied after printing such that the first layer 5 (consisting of organic resin 4 in the insulated layer 1 and the conductive component 3), and the second layer 6 (consisting of the conductive component 3) are formed, wherein the thickness of the first layer 5 is made greater than 0.3 times the average grain size of the low resistance metal grains, the wiring layer 2 is made thinner than the second layer 6, and adhesion is attained. (Refer to Fig. 1 of Patent Reference above.)

However, according to the conventional technology, although osmosis can be used when the patterns are made of fine grains, problems are that a satisfactory property such as conductivity of the pattern section is not obtained unless grain compression is carried out under a high loading condition, and that the technology cannot be adapted to miniaturized pattern formation due to volume contraction caused by the compression. Further, if the grain size is set small to attain miniaturization, the conductivity of the electric conductive section is degraded; and the finer the pattern should be, the thicker is the film thickness required to obtain adhesion power. Accordingly, there is a limitation.

Further, another conventional technology is disclosed by JPA 2000-36650 (circuit board manufacturing process). According to this Patent Reference, a great number of concavities 3, to which metal grains 2 are laid, are formed on the surface of a glossy insulating substrate 1 used as the circuit. Then, a circuit metal film 4 that is united with the metal grains 2 laid in each concavity 3 is plated and formed at places used as the circuit.

However, according to this method, the substrate has to be processed in order to lay the metal grains, and it is difficult to make the concavity in the shape of a pot, resulting in a problem in that it is difficult to obtain the adhesion of the metal grains to the base material. Further, if this method is to be applied to a miniaturized pattern, manufacturing cost rises due to precision required of the process.

Furthermore, JP No. 3431556 (an imprint medium and its manufacturing method, a manufacturing method of a wiring substrate using the imprint medium) discloses another technology. According to this technology, the surface of an aluminum substrate 101, serving as the base of an imprint medium, is selectively exposed using the photo-resist technology by photosensitive resin. Then, a metal layer 104 is formed on the exposed substrate surface by gloss plating such that metal grain growth direction is almost in parallel to the substrate surface. Then, a metal layer 105 is formed by non-gloss plating on the metal layer 104 such that metal grain growth direction is almost perpendicular to the substrate surface, and the imprint medium is obtained. Then, the obtained imprint medium is adhered by pressure to an insulating substrate 201 that has adhesives 202 on the surface, metal layers 104 and 105 serving as conductive wiring are imprinted and laid on the insulating substrate surface, the substrate 101 of the imprint medium is removed by chemical etching, and the wiring substrate is obtained.

However, according to this method, a roughening process of the metal layer 105 is required, making the manufacturing process complicated.
[Patent Reference 1] JPA 10-51089
[Patent Reference 2] JPA 2000-36650
[Patent Reference 3] Japanese Patent No. 3431556

A further conventional wiring substrate is disclosed in US patent nr. 2,585,700.

### SUMMARY OF THE INVENTION

It is a general object of the present invention to provide a pattern form object and a manufacturing method thereof that substantially obviate one or more of the problems caused by the imitations and disadvantages of the related art. This object is achieved by the invention as defined in the claims. Specifically, the present invention aims at providing a pattern form object that has good adhesion to a supporting member for low production cost, solving the problems of the conventional technology.

Features and advantages of the present invention are set forth in the description that follows, and in part will become apparent from the description and the accompanying drawings, or may be learned by practice of the invention according to the teachings provided in the description. Objects as well as other features and advantages of the present invention will be realized and attained by a pattern form object and a manufacturing method thereof particularly pointed out in the specification in such full, clear, concise, and exact terms as to enable a person having ordinary skill in the art to practice the invention.

To achieve these and other advantages and in accordance with the purpose of the invention, as embodied and broadly described herein, the invention provides as follows.

### [Solution means 1]

A first aspect of the invention provides a pattern form object comprising: a pattern including an aggregate of grains, the grains made of nano particles, the grains having high surface activity and low melting point, a supporting member made of a resin that supports the pattern; and a mixed layer formed at a boundary wherein the supporting member and the pattern are in contact with each other such that the supporting member is present between the grains that constitute the pattern, wherein dimensions of the grains are greater in an interior of the pattern than in the mixed layer because of increased fusion caused between the nano particles in the pattern than in the mixed layer; and the nano grains are made of a metal material.

### [Function]

Adhesion of the pattern to the supporting member (base material/substrate) can be simply raised by the supporting member permeating into the grain aggregate constituting the pattern under a condition that the supporting member has fluidity. The fluidity is easily obtained by using thermosetting resin and ultraviolet-ray hardening type resin, and hardening the resin after contacting the pattern. In the case of using thermoplastic resin, the fluidity can be obtained by heating, and then making the pattern contact the supporting member. In this case, a formation method especially by molding is useful.

In the mixed layer consisting of the grain aggregate and the supporting member that is made of resin as above, adhesion is more important than conductivity. For this reason, the dimensions of the grains are desired to be small such that the surface area that contacts the supporting member is great, raising adhesion power. In the portion except for the mixed layer of the pattern, i.e., the portion where conductivity is needed, the size of the grains is desired to be as great as possible to obtain practical conductivity for wiring, which is achieved by preventing as much as possible grain boundaries from being reduced.

Furthermore conductivity can be easily acquired by using the metal as the nano grains, and by carrying out thermal fusion of the nano metal grains. Accordingly, as a method of forming wiring, general-purpose printing technology like offset printing or ink jet printing can be employed in addition to conventional technologies such as plating, evaporation coating, and spattering. In this manner, choices of the manufacturing methods are widened.

### [Example 1]

Example 1 is the pattern form object as described in Solution means 1, wherein the nano particles are in a fusion state.

### [Function]

when the grain aggregate consists of nano grains, since nano grain spacing changes by osmosis of the resin the supporting member) in the mixed layer, dimensions of grains formed by fusion in the mixed layer differ from other places. At places other than the mixed layer, since grain boundaries acting as an obstacle to conductivity become denser compared with the case where they are beforehand constituted by the grain state, conductivity near bulk material is acquired. Further, in the mixed layer, since fusion of grains does not progress, although conductivity is not obtained, a void generated at the time of fusion can be decreased, and good adhesion can be obtained.

### [Example 2]

Example 2 is the pattern form object according to Solution means 1, Example 1, and Example 2, wherein the supporting member is made of a fluid resin that is hardened.

### [Function]

As the fluid resin, thermoplastic resin in a fusion state, thermosetting resin and optical hardening resin before hardening can be used. By raising the adhesion by osmosis, desired adhesion power is obtained without carrying out a special process on the pattern material itself. Especially, in the case of silver nano grains, since there is no adhesion in the material itself, this method is effective.

### [Example 3]

Example 3 is the pattern form object as described in Solution means 1, and Examples 1 and 2, wherein the pattern is embedded into the supporting member, except for the surface of the pattern.

### [Function]

Since the pattern is embedded into the supporting member such that the pattern is surrounded by the supporting member, the adhesion of the pattern is improved. In the case that the pattern is formed on a plate surface, and the supporting member is formed by adhesives imprint, for example, the side of the pattern also contacts the supporting member, and adhesion power of the pattern is improved.

### [Example 4]

Example 4 is the pattern form object as described in Solution means 1, and Examples 1 through 3, wherein the pattern is laid over a plurality of planes.

### [Function]

When forming a three-dimensional pattern, it is necessary to carry out pattern formation in two or more planes, which is difficult.

If the pattern in a bulk state is formed on an imprint sheet, and simply pasted to the supporting member by imprinting and the like, in order to make such a three-dimensional form object, problems such as disconnection will occur due to flexibility of the pattern. Further, according to a method of imposing force to acquire conductivity, problems are in that the load from the force varies, and the shape of the pattern collapses. According to the present invention, continuity (conductivity) is attained by fusing the nano grains through heating, without influencing the base material, which is advantageous.

### [Example 5]

Example 5 is the pattern form object as described in Solution means 1, and Examples 1 through 4, wherein the supporting member consists of two or more members.

### [Function]

When the supporting member is constituted by two or more members, one is prepared at a place that touches the pattern, and the other(s) serve as reinforcement to the supporting member. Practically, in order to attain satisfactory adhesion, adhesives are chosen as the supporting member that is adhered to the pattern, in which case, the adhesives are reinforced by another resin chosen from a viewpoint of dimensions and intensity. By structuring the supporting member in this way, requirements of the supporting member can be separated for each material, and choice of materials becomes great. Further, if a material chosen for the place of the supporting member that touches the pattern can be fused by heating, and the like, separation of the supporting member from the pattern can be easily performed, facilitating a recycling processing.

### [Example 6]

Example 6 is the pattern form object as described in Solution means 1, and Examples 1 through 5, wherein the supporting member has an optical transmission nature.

### [Function]

Since the supporting member has an optical 20 transmission nature, it is possible to mount an optical component. The cases wherein
a semiconductor laser is flip-chip mounted on a glass substrate,
a light emitted from a luminous source is transmitted through a glass section, and
an optical waveguide is formed in or on a glass substrate for optical transmission; correspond to the present invention wherein
a semiconductor laser is mounted in the pattern form object, and is transmitted through the pattern form object,
a light emitted from a luminous source is transmitted through the supporting member, and
an optical waveguide is formed to the pattern form object for optical transmission, respectively.

### [Example 7]

Example 7 is the pattern form object as described in Example 6, wherein the supporting member is made of ultraviolet-ray hardening type resin.

### [Function]

Since the supporting member is made of ultraviolet-ray hardening resin, the pattern can be formed on the supporting member in a short time. An advantage of hardening in the short time is in that the function of the pattern is not degraded, because osmosis of the adhesives between the grains of the pattern can be reduced. For example, when forming wiring, fusion of metal nano grains is reduced, and conductivity is reduced as adhesives permeate; therefore, it is important to prevent adhesives permeating to the center of the pattern. Further, an optical component can be mounted on the pattern form object using the optical transmission nature of ultraviolet-ray hardening resin (refer to Example 7).

### [Example 8]

Example 8 is the pattern form object as described in Solution means 1, and Examples 1 through 7, wherein the pattern consists of two or more pattern layers.

### [Function]

By laminating two or more patterns one by one, it is possible to form a multilayer pattern. In the case of wiring, this provides multilayer wiring, enabling forming wiring of a three-dimensional object in a small area. Further, a multilayer wiring board can be formed in the shape of a plane.

### [Solution means 2]

Another aspect of the present invention provides Solution means 2, which is a manufacturing method of the pattern form object as described in Solution means 1 and Examples 1 through 8, characterized by: a step of forming the pattern with ink that contains the grains made of the nano particles on a mold; a step of forming the supporting member with fluid material so that the pattern is covered by the supporting member; and a step of forming the grain aggregate by growing the grains by heating and fusing the nano grains after hardening the supporting member, and then taking out the pattern form object from the mold after cooling.

### [Function]

The pattern form object as described in Solution means 1, and Examples 1 through 10 is manufactured by fusing the nano grains that constitute the pattern after permeating the fluid supporting material that serves as the pattern supporting member. At this time, the thickness of the permeation is controlled by controlling a time of the permeation of the fluidity supporting material into the nano grains until the permeation is to stop (i.e., until when the fluidity of the supporting material is lost).

### [Solution means 3]

Another aspect of the present invention provides Solution means 3, which is a manufacturing method of the pattern form object as described in Solution means 1, and Examples 1 through B, characterized by: a step of forming the pattern with ink that contains the grains made of the nanoparticles on a mold; a step of forming the supporting member with fluid material so that the pattern is covered by the supporting member; and a step of forming the grain aggregate by growing the grains by heating and fusing the nano grains and simultaneously hardening the supporting member, and then taking out the pattern form object from the mold after cooling.

### [Function]

If the osmosis of the fluid supporting member material to the pattern is excessive with Solution means 2, this Solution means 3 is employed, wherein the pattern fusion and the supporting member material hardening simultaneously take place, and the pattern form object is manufactured. Further, it is also possible to shorten the heating time, and when using thermoplastic resin, since high-temperature resin contacts the pattern, fusion of the nano grains instantly takes place; therefore, hardening takes a shorter time

### [Example 9]

Example 9 is the manufacturing method as described in Solution means 2 and Solution means 3, wherein components are formed on the pattern in one body.

### [Function]

By arranging components such as an electronic component and an optical component in the three-dimensional object, a high-performance device can be easily manufactured as available by the conventional packaging. This is an effective method especially when it is difficult to mount a component in the three-dimensional form at a later stage, and when aiming at further miniaturization.

### [Example 10]

Example 10 is the manufacturing method as described in Solution means 2 and Solution means 3, wherein wiring is formed along the pattern.

### [Function

Since the pattern is constituted by the grain aggregate, depending on functions required, it may become a problem. The problem can be solved by providing a functional material on the pattern after forming the pattern on the supporting member. It is possible to carry out copper plating and to form wiring on the pattern, using the pattern formed on the supporting member (base material). In this case, adhesion to the supporting member is obtained, and various shapes of members can be formed. It is also possible to finely form wiring in a three-dimensional object. Since copper grains are easy to be oxidized, forming copper wiring is not easy. In this case, the pattern is first formed with silver nano grains, obtaining conductivity, and then copper plating is performed. aggregate while, at the same time, the supporting member is hardened, and the grain aggregate is taken out from the mold after cooling.

### [Function]

If the osmosis of the fluid supporting member material to the pattern is excessive with Solution means 2, this Solution means 3 is employed, wherein the pattern fusion and the supporting member material hardening simultaneously take place, and the pattern form object is manufactured. Further, it is also possible to shorten the heating time, and when using thermoplastic resin, since high-temperature resin contacts the pattern, fusion of the nano grains instantly takes place; therefore, hardening takes a shorter time.

### [Example 11]

Example 11 is the manufacturing method as described in Solution means 2 and Solution means 3, wherein components are formed on the pattern in one body.

### [Function]

By arranging components such as an electronic component and an optical component in the three-dimensional object, a high-performance device can be easily manufactured as available by the conventional packaging. This is an effective method especially when it is difficult to mount a component in the three-dimensional form at a later stage, and when aiming at further miniaturization.

### [Example 12]

Example 12 is the manufacturing method as described in Solution means 2 and Solution means 3, wherein wiring is formed along the pattern.

### [Function]

Since the pattern is constituted by the grain aggregate, depending on functions required, it may become a problem. The problem can be solved by providing a functional material on the pattern after forming the pattern on the supporting member. It is possible to carry out copper plating and to form wiring on the pattern, using the pattern formed on the supporting member (base material). In this case, adhesion to the supporting member is obtained, and various shapes of members can be formed. It is also possible to finely form wiring in a three-dimensional object. Since copper grains are easy to be oxidized, forming copper wiring is not easy. In this case, the pattern is first formed with silver nano grains, obtaining conductivity, and then copper plating is performed.

Further, functional patterns, such as wiring, can be formed not only by plating, but also by ink jetting and a dispenser that are not designed for fine supply by beforehand forming the pattern having hydrophilic/hydrophobic nature in the three-dimensional object. This is especially effective when a thick film is to be manufactured, with choices of manufacturing processes widening.

### [Effect of the Invention]

The present invention proposes the pattern formation method, wherein adhesion to the supporting member is enhanced using the permeability of the supporting member to the grains that constitute the pattern without special fabrication or process. That is, the adhesion is enhanced by forming the mixed layer wherein the pattern and the supporting member are mixed at the boundary of the two elements. Since the grains constituting the pattern are fine, such as nano grains, uniform osmosis is obtained, and the nano grains are fused in the pattern by the surface activity power of the nano grains, producing a continuous granular structure. Since the nano grains are not fused as much in the region where the supporting member has permeated (i.e., the mixed layer), granular structures tend not to be continuous in the mixed layer as compared with the pattern at other than the mixed layer, cavities (voids) due to condensation of the grains at the time of fusion are prevented from occurring, and firm interface adhesion can be obtained.

The effects of the present invention are as follows.
(1) By the mixed layer formed by osmosis of the supporting member material into the grains that form the pattern, the pattern having great adhesion power can be formed. Especially, since the size of the grains in the mixed layer is smaller than the grains in the portion except for the mixed layer in the pattern, adhesion power between the pattern and the supporting member is raised further
(2) By using the form of the nano grains, the pattern having the great adhesion power is easily formed. Further, since the nano grains are easy to be fused, they can form a detailed pattern that cannot be easily collapsed.
(3) By using low-temperature fusion of the nano grains, wiring can be easily formed.
(4) By using osmosis of the fluid resin as the material of the supporting member, the pattern having great adhesion power is easily formed.
(5) Since osmosis of the fluid resin can be also applied to the sides of the pattern, the pattern has an excellent exfoliation-proof characteristic.
(6) Since the pattern is constituted by a granular pattern using fusion of the grains, the pattern is not disconnected even when the pattern is formed in two or more planes.
(7) By choosing and using two or more supporting members, improvement in the adhesion power and increase of the intensity of the pattern form object are obtained.
(8) By selecting a material having an optical transmission nature toward the supporting member, an optical component can be mounted. Further, formation of an optical waveguide is also possible.
(9) By using an ultraviolet-ray hardening type resin for the supporting member, hardening time required is shortened, and osmosis of the resin into the pattern can be reduced.
(10) Since the pattern is formed by a type and mold made of a hydrophilic/hydrophobic material, the pattern can be easily formed by supplying nano grains in one shot to the type and mold.
(11) By imprinting the pattern a number of times, a multilayer pattern in three-dimensional form can be easily formed. Further, when the pattern is wiring, the pattern becomes multilayer wiring, and the wiring in three dimensions are formed in a small area. Accordingly, a multilayer wiring board can be formed in the shape of a plane.
(12) By fusing the nano grains after the fluid resin has permeated between the nano grains forming the pattern and is hardened, it is unnecessary to impose force on the nano grains, and a pattern having excellent adhesion power is easily formed.
(13) By simultaneously carrying out the nano grain fusion (the pattern material) and the fluid resin hardening (the supporting member material), the heating time can be shortened.
(14) Since a functional component can be mounted in one body, miniaturization is possible. Further, a transmission line can be made short, attaining a high performance.
(15) By making the pattern with a thick film, wiring having excellent conductivity can be formed.

### BRIEF DESCRIPTION OF THE DRAWINGS

Fig. 1 gives a perspective view of a pattern form object according to Embodiment 1 of the present invention, and a partial expanded view thereof;
Figs. 2A through 2D are cross-sectional views for explaining the manufacturing method of a wiring pattern for determining the effect related to the pattern form object according to Embodiment 1;
Fig. 3 gives a cross-sectional view of the pattern form object formed on a supporting member that has a corner section, and an exploded view thereof;
Figs. 4A through 4D are cross-sectional views for explaining the manufacturing method of the pattern form object in three dimensions according to Embodiment 2 of the present invention;
Figs. 5A through 5E are cross-sectional views for explaining the manufacturing method of the pattern form object in three dimensions according to Embodiment 3 of the present invention;
Figs. 6A through 6E are cross-sectional views for explaining the manufacturing method of the pattern form object in three dimensions, wherein a Si chip is connected according to Embodiment 4 of the present invention; and
Figs. 7A through 7D are cross-sectional views for explaining the manufacturing method of the pattern form object in three dimensions, wherein a multilayer wiring is formed according to Embodiment 5 of the present invention.

### DESCRIPTION OF THE PREFERRED EMBODIMENTS

In the following, embodiments of the present invention are described with reference to the accompanying drawings.

### [Best Mode of Carrying Out the Invention]

The object of the present invention is to enhance adhesion of a pattern to a supporting member comparatively simply and cheaply, and is achieved by providing a mixed layer wherein the dimensions of the grains are greater in an interior of the pattern than in the mixed layer.

### [Embodiment 1]

Embodiment 1 of the present invention is explained referring to Fig. 1, 2A through 2D, and 3.

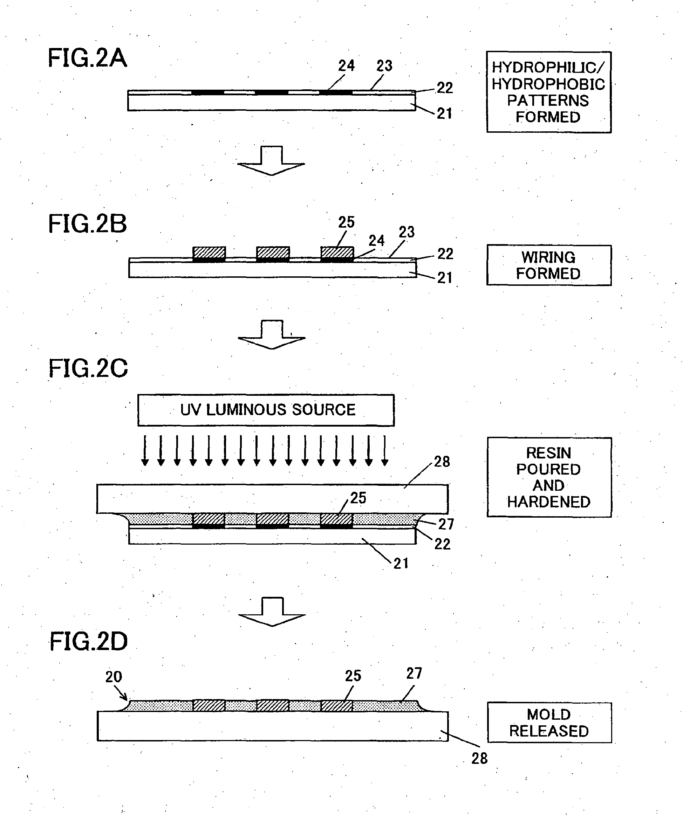

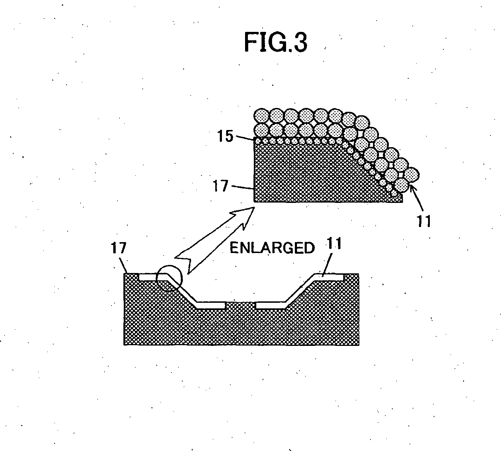

Fig. 1 is a cross-sectional view of a pattern form object formed on a supporting member according to Embodiment 1. Figs. 2A through 2D are cross-sectional views for explaining a manufacturing method of a wiring pattern for determining the effect related to the pattern form object according to Embodiment 1. Fig. 3 is a cross-sectional view of the pattern form object formed on the supporting member that has a corner section.

A pattern form object 10 includes a pattern 11 that is constituted by an aggregate 12 of grains (a granular material), a supporting member 13, and a mixed layer 15 that is produced at the boundary of the aggregate 12 and the supporting member 13, wherein the supporting member 13 touches the grains of the aggregate 12, and permeates into the grains such that the mixed layer 15 is formed. The grains of the pattern 11 are bonded to constitute the aggregate 12 by intermolecular force, hydrogen bond, and local covalent bond. If the grains are metal grains, metallic bond is also applicable. From another viewpoint, the pattern 11 is structured such that the supporting member 13 can permeate into the pattern 11.

The objectives of the present invention can be attained by using nano grains, the size of each grain ranging from several nm to tens of nm in diameter. The nano grains have high surface activity, and for this reason, the melting point is lower than a bulk material. Therefore, after arranging the nano grains in the shape of a pattern, heat is applied such that the grains start fusing and growing. The grains are fused to constitute greater grains; however, since the melting point is raised when the size of the greater grains becomes greater than a certain size, fusion does not take place.

The fusion is influenced by the temperature and a contact state between the grains. Accordingly, the supporting member 13, which is resin and is present between the nano grains by osmosis, reduces fusion of the nano grains. Therefore, the grain size becomes great inside the pattern 11 (i.e., the portion except the mixed layer 15) where the fusion progresses when heated, but the grain size does not become as great in the mixed layer 15 where the fusion progress is small. In this manner, i.e., by forming the mixed layer 15 in the pattern 11, a disadvantage of the nano grains in that the adhesion power is small is overcome, and the pattern 11 having high adhesion power toward the supporting member 13 can be easily formed.

Since the growth rate of the grain size by fusion depends on heating temperature and time, the size of the grains in the interior of the pattern 11 and the size of the grains in the mixed layer 15 can be controlled by adjusting the heating temperature and time. For example, when the average diameter of the grains in the mixed layer 15 is 50 nm, the average diameter of the grains inside the pattern 11 is 100 nm or greater, i.e., the grain-size ratio is approximately 1:2. In this manner, i.e., by making the size of the grains in the mixed layer 15 smaller than the size of the grains inside the pattern 11, the adhesion power of the pattern to the supporting member can be further increased.

In order to determine the effect of the pattern form object (grain structure) according to Embodiment 1, a pattern form object having a 200 µm wide circuit pattern formed on a white sheet glass (100x100x1 mm) as shown in Figs. 2A through 2D was produced as follows.

First, on a PET film 21, fluorine-containing acrylate (TG-702, Daikin Industries product) was applied by spray coating, and a fluorine-containing acrylate film 22 was formed. Then, the PET film 21 was immersed in ethylene glycol heated at 90 °C for 30 seconds such that it is made hydrophilic. Next, the 200 µm wide pattern was formed by drawing by semiconductor laser (L8933, product made by Hamamatsu Photonics K.K.), and by making the fluorine containing acrylate film 22 hydrophobic (i.e., a hydrophobic section 23 is formed), the 200 µm wide pattern being served by a hydrophilic section 24 as shown in Fig. 2A. Then, a silver colloidal suspension (Fine Sphere SVW102 made by Nippon Paint Co. Ltd.) was supplied to the version (status of manufacturing method) shown by Fig. 2A by dipping, and a pattern 25 constituted by silver grains was formed only in the hydrophilic section 24 of the fluorine containing acrylate film 22 as shown by Fig. 2B.

Next, ultraviolet-ray hardening resin 27 (SD-2200, made by Dainippon Ink and Chemicals, Inc.) is supplied on a white sheet glass substrate 28 by a dispenser, to which the version shown by Fig. 2B is pasted, and ultraviolet-rays are irradiated from the side of the white sheet glass. The ultraviolet-ray irradiation was carried out at an intensity of 15 mW/cm² for 10 seconds as shown by Fig. 2C. The version was removed from the glass substrate 28 after hardening of the ultraviolet-ray hardening resin 27, and the pattern 25 that was 200 µm wide was formed on the white sheet glass substrate 28 as shown by Fig. 2D. Then, hardening was performed for 30 minutes at 150 °C, and the pattern form object 20 having conductivity was manufactured.

Exfoliation tests were carried out on the pattern (wiring) formed as above, using an adhesion tape "Nice Tac" (made by and trademark of Nichiban Co., Ltd.). Here, the exfoliation tests were carried out in two stages, i.e., one after imprinting on the ultraviolet-ray hardening type resin, and the other after hardening for 30 minutes at 150 °C. In both cases, adhesion to the adhesion tape was not observed, and it was determined that the conductivity was maintained.

For comparison purposes, another pattern having the same 200 µm width was formed by supplying the same ultraviolet-ray hardening resin (SD-2200) by the dispenser on a white sheet glass, carrying out the flattening by squeegee, hardening by ultraviolet-ray irradiation, applying the silver colloid solution (Fine Sphere SVW102) by the dispenser, and hardening for 30 minutes at 150 °C. It was determined that conductivity was acquired. The exfoliation tests were carried out before and after hardening for 30 minutes at 150 °C. In the exfoliation examination before hardening, the imprint of the pattern on the adhesion tape was observed, and although the pattern remained on the substrate to some extent, conductivity was not acquired. On the other hand, in the exfoliation test after hardening, adhesion on the adhesion tape was not observed, and conductivity was obtained.

Further, another pattern having the 200 µm width was similarly formed by silver colloid solution on a white sheet glass substrate using the dispenser. Hardening was carried out for 30 minutes at 150 °C as above. In the exfoliation tests both before and after hardening, exfoliation was observed and conductivity was not obtained.

From above, it was determined that a layer that is stuck to the interface between the resin and the nano grains is necessary in order to obtain the adhesion of the nano grains, and that adhesion power was raised by using osmosis of the resin.

According to measurements using a scanning electron microscope (SEM), average grain size was about 50 nm; and inside the pattern 11, the average was about 100 nm. From this, it is considered that the fusion state changed with osmosis of the resin. Furthermore, concavities due to fusion were found inside the pattern 11 at grain boundaries; however, no concavities were found within the mixed layer 15, since osmosis of the resin and the effects of fusion were small. Namely, it was determined that the grain size distribution as shown in Fig. 1 was obtained.

Further, the present invention is advantageous in mounting the pattern 11 to a curved surface, and two or more planes, since the pattern 11 is formed by granular material and has excellent continuity. Otherwise, e.g., when the pattern is a bulk object, at a section where two planes meet (refer to Fig. 3), a rounding process or providing another structure to make the corner round is required such that the pattern would not be damaged (wire broken).

On the other hand, since the pattern 11 is constituted by the granular objects according to the present invention, the pattern 11 can be formed continuously without disconnections even if the pattern 11 is laid along the corner. Especially, when using metal nano grains for forming wiring, the nano grains are provided in the shape of the desired pattern, and fused; accordingly, the wiring can be formed satisfactorily also at the cornering portion. In this manner, excellent continuity on a curved surface can be provided by the pattern formation of the present invention, compared with a bulk object.

### [Embodiment 2]

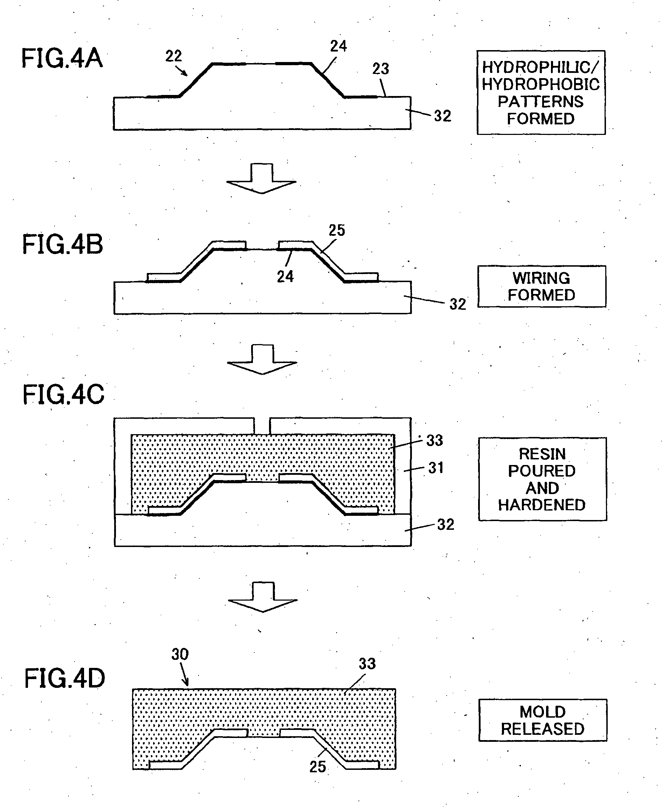

Embodiment 2 of the present invention is explained referring to Fig. 4, which shows the manufacturing method of the pattern form object in three dimensions.

First, an upper mold 31 and a lower mold 32 were manufactured by cutting metal blocks of aluminum as the molds to be used when casting the three-dimensional pattern form object.

Next, to the lower mold 32, fluorine-containing acrylate (TG-702 made by Daikin Industries) was applied by spray coating, and a fluorine-containing acrylate film 22 was formed. Then, the lower mold 32 was immersed in ethylene glycol that was heated at 90 °C for 30 seconds, i.e., a hydrophilic process was performed. Then, a pattern was drawn using a semiconductor laser (L8933), the fluorine containing acrylate film 22 was changed from hydrophilic to hydrophobic such that a hydrophobic pattern 23 was formed, and a hydrophilic pattern 24 was formed, the width of which was 50 µm as shown by Fig. 4A.

The version to which the hydrophilic/hydrophobic patterns were formed, i.e., the lower mold 32, was then dipped in a silver colloidal suspension (Fine Sphere SVW102) such that silver nano grains were adhered only to the hydrophilic section 24, and a pattern 25 was formed as shown by Fig. 4B. Then, the silver nano grains constituting the pattern 25 were dried. Then, the upper mold 31 was placed on the lower mold 32, fast set two-part liquid epoxy resin 33 (ARALDITE® made by Huntsman Advanced Materials, Inc.) was poured inside the molds, and left at 60 °C for 5 hours as shown by Fig. 4C. Then, the molds were released (separated) as shown by Fig. 4D, and a three-dimensional object was obtained, which was hardened for 30 minutes at 150 °C. In this way, the three-dimensional pattern form object 30, having the 50 µm wide circuit pattern was manufactured.

Further, the circuit pattern of the pattern form object 30 was thickened so that a current density of 4 A/cm² and a theoretical thickness of 10 µm are obtained by pyrophosphoric-acid bath copper plating at 20 °C. Since it is difficult to make a thick film only by the nano grains, the thick film was obtained as above so that required current capacity and conductivity are obtained.

Although Embodiment 2 is explained taking the case where pattern formation is carried out on a 3-dimensional object, the present invention can be applied not only to the cases where the pattern form object is formed on two or more planes and curved surfaces, but also to the cases where the pattern form object is to be formed in one plane, such as a printed circuit board. In this case, since what is necessary is just to form a pattern on a plane, highly flexible design is possible, such as miniaturization.

Although Embodiment 2 is explained taking the case where the hydrophilic and hydrophobic patterns are formed by the laser heating the hydrophilic pattern film, the method is not limited to this. The following method can be used to form the hydrophilic/hydrophobic patterns. A hydrophobic layer such as a silicone layer is applied to a hydrophilic pattern, and the hydrophobic layer is removed by laser heating. Further, it is also possible to form a hydrophilic pattern by using photocatalyst of anatase-type titanium dioxide. Specifically, a titanium-oxide film is formed on a mold for forming a three-dimensional object, and ultraviolet rays are irradiated to a part where a hydrophilic pattern should be formed. In this way, a hydrophilic pattern can also be formed.

Further, another method of forming a pattern on a mold is considered, where a pattern formed on a plane is pasted to a mold. In this case, since the pattern is formed on a film, formation of the pattern on a curved surface is possible.

Although the pattern was hardened after the supporting member was completely hardened according to Embodiment 2, simultaneous hardening of the pattern and the supporting member is also possible. This is effective especially when restricting osmosis of the supporting member to the pattern. Further, shortening of the process time can be aimed at.

Further, according to Embodiment 2, since the hydrophilic/hydrophobic patterns are used, the patterns are embedded in the supporting member. In this case, since the patterns contact the supporting member at places other than the surface, the patterns have greater adhesion power.

Furthermore, the formation method of a pattern is not limited to using the hydrophilic pattern, but letterpress (relief printing) and intaglio (engraved plate) may be used. Especially, when a pattern is formed on a convex section, it has the feature that it is easy to form the pattern if the pattern is surrounded by the supporting member.

Further, pattern formation can also be carried out by directly drawing a pattern on a mold with a dispenser or an ink jet method. In the case of the pattern formation method using the ink jet method, the silver colloidal suspension used by Embodiment 2 can also be used. Here, the suspension is not especially limited unless viscosity is high. If the silver colloidal ethanol suspension (Fine Sphere SVE102) is chosen, for example, the volatilization time of the suspension can be shortened.

Further, by forming the supporting member by material that has an optical transmission characteristic like ultraviolet-ray hardening resin, an optical component can be mounted. In this case, it is possible to form the pattern form object by providing a structure member made of ultraviolet-ray hardening type resin (SD-2200).

Although at Embodiment 2, the forming method of a circuit pattern is described, the forming method is not limited to forming a conductive pattern, but also applicable to forming a pattern of metal, semiconductor and insulator, since the essential objective of the present invention is to enhance adhesion power of a pattern object that is constituted by grains, and the objective is achieved as described herein.

### [Embodiment 3]

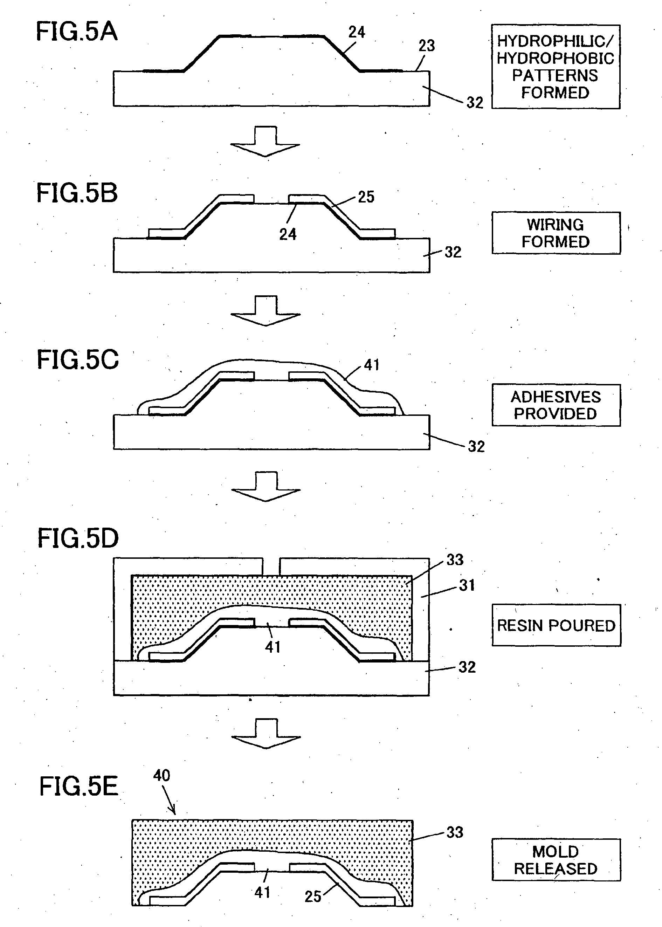

Next, Embodiment 3 of the present invention is explained referring to Figs. 5A through 5E, which show the manufacturing method of the pattern form object in three dimensions.

Embodiment 3 down to the process shown by Fig. 5B is the same as Embodiment 2 of forming the pattern 25 on the lower mold 32 (refer to Fig. 4B). On the mold (Fig. 5B) formed by the same method as Embodiment 2, the ultraviolet-ray hardening type resin (SD-2200) serving as an adhesives 41 was provided by a dispenser so that the pattern 25 was surrounded as shown by Fig. 5C, and ultraviolet-ray hardening was performed for 10 seconds at 15 mW/cm². Then, after the upper mold 31 is placed on the lower mold 32, the fast set type two-part epoxy resin 33 ARALDITE (made by Huntsman) was used to fill inside the molds, and it was left at 60 °C for 5 hours (Fig. 5D). Then, the three-dimensional body was released from the molds (Fig. 5E), and hardening was performed for 30 minutes at 150 °C. Thus, the pattern form object 40 having the circuit pattern width of 50 µm was formed on the three dimensional object.

By the adhesives 41 quickly adhering to the pattern 25, the adhesion of the pattern 25 is obtained, and oozing of the adhesives into the pattern 25 can be reduced. Although Embodiment 3 is described about the case wherein the pattern was formed in a three dimensional box shape, the present invention can be applied to other cases wherein a pattern is formed on a flat object like a printed circuit board.

### [Embodiment 4]

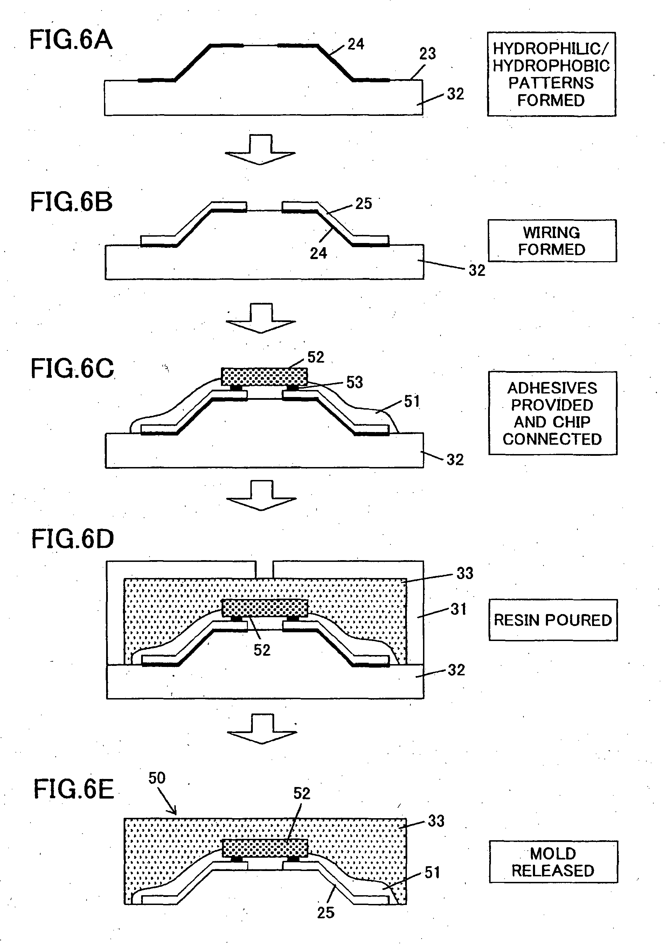

Embodiment 4 of the present invention is explained referring to Figs. 6A through 6E, which show the manufacturing method of the pattern form object in three dimensions, to which a Si chip is connected.

The manufacturing method of Embodiment 4 shares the same steps as Embodiment 3 to the extent that adhesives 51 were supplied so as to surround the pattern 25 formed in the lower mold 32. Then, according to Embodiment 4, a Si chip 52 having vamps 53 made of conductive adhesives DOTITE XA-910 (made by FUJIKURA KASEI Co. Ltd.) is mounted as shown in Fig. 6C.

Here, the width of the pattern was set at 200 µm, and the above-mentioned adhesives 51 were provided as epoxy resin for underfill (product made by NAMICS). The Si chip 52 was connected by a flip chip bonder (CB-500, made by Misuzu FA [name changed to Athlete FA K.K.]). In the connection process, temporary hardening was performed from the tip side by pulse heating for 2 minutes at 200 °C. Here, the Si chip 52 contained an Au pattern all over for ascertaining conductivity.

Then, the conductive adhesives, the epoxy resin for underfill, and the silver nano grains were hardened for 30 minutes at 150 °C, the upper mold 31 was placed on the lower mold 32, ARALDITE was poured into the molds, and it was left at room temperature for 24 hours (Fig. 6D). Then, the three-dimensional object was released from the molds (Fig. 6E), and connection of the Si chip 52 was ascertained by determining conductivity. In this manner, the pattern form object 50 in three dimensions, bearing the Si chip was manufactured.

### [Embodiment 5]

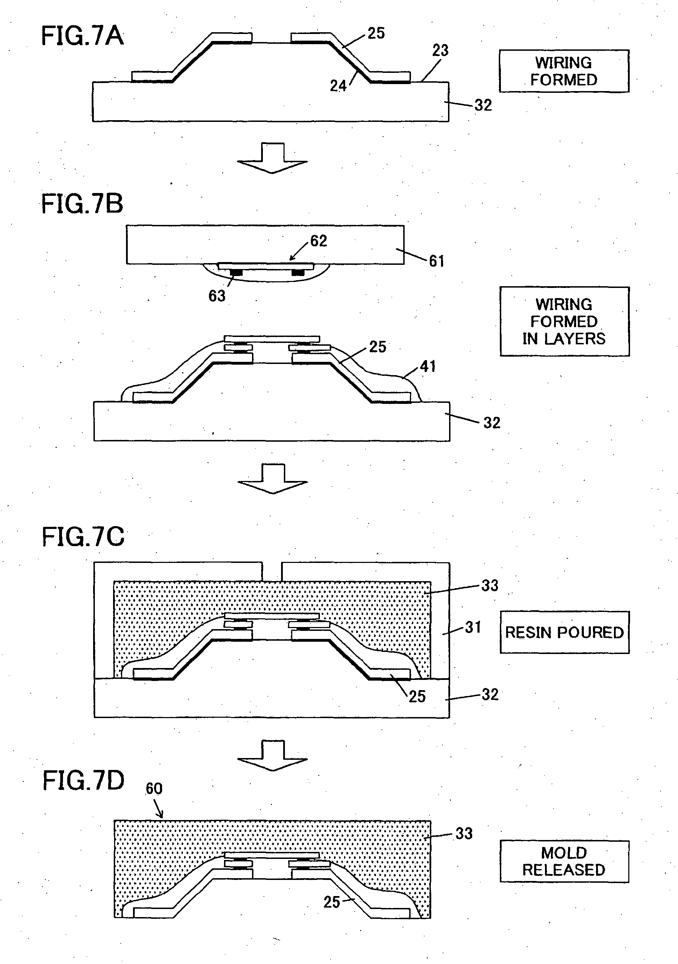

Embodiment 5 of the present invention is explained referring to Figs. 7A through 7D, which show the manufacturing method of the pattern form object in three dimensions wherein a multilayer wiring was formed.

According to Embodiment 5, hydrophilic/hydrophobic patterns were formed with fluorine containing acrylate on a PET film 61, a silver colloidal suspension (Fine Sphere SVW102) was supplied on it, and dried such that an imprint member 62 serving as a circuit pattern was formed as in the manufacturing method of Embodiment 1 (Fig. 2A and Fig. 2B). Then, the vamps 63 were formed by providing the conductive adhesives DOTITE XA-910 on nano grains of the imprint member 62, and dried (Fig. 7B).

Then, the pattern 25 was formed on the mold (Fig. 7A) like in Embodiment 3 (Fig. 5B), ultraviolet-ray hardening type resin serving as the adhesives 41 was supplied on the pattern 25 using a dispenser. Then, the PET film 61 to which the imprint member 62 was formed was stuck to the pattern 25, and hardening by ultraviolet rays was performed. Then, the PET film 61 was removed, and another circuit pattern (the imprint member 62) was formed on the pattern 25. The multilayer wiring pattern was formed by repeating the formation of additional circuit patterns (the imprint member 62) (Fig. 7B).

Then, the upper mold 31 was placed on the lower mold 32, the fast set type two-part epoxy resin 33 ARALDITE (made by Huntsman Advance Materials) was poured into the molds, the conductive adhesives and the silver nano grains were hardened for 30 minutes at 150 °C, and it was left at room temperature for 24 hours (Fig. 7C). Then, a pattern form object 60 in three dimensions, to which the multilayer wiring was formed was obtained by releasing the three-dimensional object from the molds (Fig. 7D).

## Claims

1. A pattern form object comprising:
a pattern including an aggregate of grains, the grains made of nano particles, the grains having high surface activity and low melting point,
a supporting member made of a resin that supports the pattern; and
a mixed layer formed at a boundary wherein the supporting member and the pattern are in contact with each other such that the supporting member is present between the grains that constitute the pattern, **characterized in that** the dimensions of the grains are greater in an interior of the pattern than in the mixed layer because of increased fusion caused between the nano particles in the pattern than in the mixed layer; and
the nano grains are made of a metal material.

2. A pattern form object as claimed in Claim 1, **characterized in that** the nano particles are in a fusion state.

3. A pattern form object as claimed in Claim 1, **characterized in that** the supporting member is made of fluid resin that is hardened.

4. A pattern form object as claimed in Claim 1, **characterized in that** the pattern is embedded into the supporting member except for a surface of the pattern.

5. A pattern form object as claimed in Claim 1, **characterized in that** the pattern is laid over a plurality of planes.

6. A pattern form object as claimed in Claim 1, **characterized in that** the supporting member consists of a plurality of members.

7. A pattern form object as claimed in Claim 1, **characterized in that** the supporting member has an optical transmission characteristic.

8. A pattern form object as claimed in Claim 7, **characterized in that** the supporting member is made of ultraviolet-ray hardening type resin.

9. A pattern form object as claimed in Claim 1, **characterized in that** the pattern is structured by a plurality of layers.

10. A manufacturing method of the pattern form object as claimed in claim 1, **characterized by**:
a step of forming the pattern with ink that contains the grains made of the nano particles on a mold;
a step of forming the supporting member with fluid material so that the pattern is covered by the supporting member; and
a step of forming the grain aggregate by growing the grains by heating and fusing the nano grains after hardening the supporting member, and then taking out the pattern form object from the mold after cooling.

11. A manufacturing method of the pattern form object as claimed in Claim 1, **characterized by**:
a step of forming the pattern with ink that contains the grains made of the nano particles on a mold;
a step of forming the supporting member with fluid material so that the pattern is covered by the supporting member; and
a step of forming the grain aggregate by growing the grains by heating and fusing the nano grains and simultaneously hardening the supporting member, and then taking out the pattern form object from the mold after cooling.

12. A manufacturing method as claimed in any one of Claims 10 and 11, **characterized in that** a functional component is formed on the pattern in one body.

13. A manufacturing method as claimed in any one of Claims 10 and 11, **characterized in that** wiring is formed along with the pattern.

## Patentansprüche

1. Musterformgebilde umfassend:
ein Muster, das eine Anhäufung vor Körnern umfasst, wobei die Körner aus Nanoteilchen hergestellt sind, wobei die Körner eine hohe Oberflächenaktivität und einen niedrigen Schmelzpunkt aufweisen,
ein Trägerteil, das aus einem Harz hergestellt ist, das das Muster trägt; und
eine gemischte Schicht, die an einer Grenzfläche gebildet ist, wobei das Trägerteil und das Muster derart in Kontakt miteinander stehen, dass das Trägerteil zwischen den Körnern, die das Muster bilden, vorliegt, **dadurch gekennzeichnet, dass** die
Dimensionen der Körner in einem Innenteil des Musters größer sind als in der gemischten Schicht wegen der stärkeren Fusion, die zwischen den Nanoteilchen in dem Muster als in der gemischten Schicht verursacht wird; und
die Nanokörner aus einem Metallmaterial hergestellt sind.

2. Musterformgebilde nach Anspruch 1, **dadurch gekennzeichnet, dass** die Nanoteilchen sich in einem Fusionszustand befinden.

3. Musterformgebilde nach Anspruch 1, **dadurch gekennzeichnet, dass** das Trägerteil aus gehärtetem Fluidharz hergestellt ist.

4. Musterformgebilde nach Anspruch 1, **dadurch gekennzeichnet, dass** das Muster in das Trägerteil mit Ausnahme einer Oberfläche des Musters eingebettet ist.

5. Musterformgebilde nach Anspruch 1, **dadurch gekennzeichnet, dass** das Muster über eine Mehrzahl von Ebenen gelegt ist.

6. Musterformgebilde nach Anspruch 1, **dadurch gekennzeichnet, dass** das Trägerteil aus einer Mehrzahl von Teilen besteht.

7. Musterformgebilde nach Anspruch 1, **dadurch gekennzeichnet, dass** das Trägerteil eine optische Übertragungscharakteristik aufweist.

8. Musterformgebilde nach Anspruch 7, **dadurch gekennzeichnet, dass** das Trägerteil aus einem durch Ultraviolettstrahlung härtenden Typ Harz hergestellt ist.

9. Musterformgebilde nach Anspruch 1, **dadurch gekennzeichnet, dass** das Muster durch eine Mehrzahl von Schichten strukturiert ist.

10. Herstellungsverfahren des Musterformgebildes nach Anspruch 1, **gekennzeichnet durch**:
einen Schritt des Bildens des Musters mit Tinte, die die aus den Nanoteilchen hergestellten Körner enthält, in einer Form;
einen Schritt des Bildens des Trägerteils mit Fluidmaterial, so dass das Muster durch das Trägermaterial bedeckt ist; und
einen Schritt des Bildens der Kornanhäufung **durch** Züchten der Körner **durch** Erhitzen und Schmelzen der Nanokörner nach dem Härten des Trägerteils und dann Herausnehmen des Musterformgebildes aus der Form nach dem Kühlen.

11. Herstellungsverfahren für das Musterformgebilde nach Anspruch 1, **gekennzeichnet durch**:
einen Schritt des Bildens des Musters mit Tinte, die die aus den Nanoteilchen hergestellten Körner enthält, in einer Form;
einen Schritt des Bildens des Trägerteils mit Fluidmaterial, so dass das Muster durch das Trägermaterial bedeckt ist; und
einen Schritt des Bildens der Kornanhäufung **durch** Züchten der Körner **durch** Erhitzen und Schmelzen der Nanokörner und gleichzeitigen Härtens des Trägerteils und dann Herausnehmens des Musterformgebildes aus der Form nach dem Kühlen.

12. Herstellungsverfahren nach einem der Ansprüche 10 und 11, **dadurch gekennzeichnet, dass** eine funktionelle Komponente auf dem Muster in einem Stück gebildet wird.

13. Herstellungsverfahren nach einem der Ansprüche 10 und 11, **dadurch gekennzeichnet, dass** die Verdrahtung zusammen mit dem Muster gebildet wird.

## Revendications

1. Objet à motif structuré comprenant:
un motif incluant un agrégat de grains, les grains étant constitués de nanoparticules, les grains ayant une activité de surface élevée et un faible point de fusion,
un élément de support en résine qui soutient le motif; et
une couche mixte formée à une frontière dans laquelle l'élément de support et le motif se trouvent en contact l'un avec l'autre de sorte que l'élément de support soit présent entre les grains qui constituent le motif, **caractérisé en ce que**
les dimensions des grains sont supérieures dans une partie interne du motif par rapport à la couche mixte du fait de la fusion accrue provoquée entre les nanoparticules dans le motif par rapport à l'intérieur de la couche mixte; et
les nano grains sont constitués d'un matériau métallique.

2. Objet à motif structuré tel que revendiqué selon la revendication 1, **caractérisé en ce que** les nanoparticules se trouvent en un état de fusion.

3. Objet à motif structuré tel que revendiqué selon la revendication 1, **caractérisé en ce que** l'élément de support est constitué d'une résine fluide qui est durcie.

4. Objet à motif structuré tel que revendiqué selon la revendication 1, **caractérisé en ce que** le motif est enchâssé dans l'élément de support excepté pour ce qui concerne une surface du motif.

5. Objet à motif structuré tel que revendiqué selon la revendication 1, **caractérisé en ce que** le motif est superposé sur une pluralité de plans.

6. Objet à motif structuré tel que revendiqué selon la revendication 1, **caractérisé en ce que** l'élément de support est constitué d'une pluralité d'éléments.

7. Objet à motif structuré tel que revendiqué selon la revendication 1, **caractérisé en ce que** l'élément de support a une caractéristique de transmission optique.

8. Objet à motif structuré tel que revendiqué selon la revendication 7, **caractérisé en ce que** l'élément de support est constitué d'une résine à durcissement par rayonnement ultraviolet.

9. Objet à motif structuré tel que revendiqué selon la revendication 1, **caractérisé en ce que** le motif est structuré par une pluralité de couches.

10. Procédé de fabrication de l'objet à motif structuré tel que revendiqué selon la revendication 1, **caractérisé par**:
une étape de formation du motif avec de l'encre qui contient les grains constitués des nanoparticules sur un moule;
une étape de formation de l'élément de support avec un matériau fluide de sorte que le motif soit recouvert de l'élément de support; et
une étape de formation de l'agrégat de grains par croissance des grains par chauffage et fusion des nanograins après durcissement de l'élément de support, et ensuite sortie de l'objet à motif structuré du moule après refroidissement.

11. Procédé de fabrication de l'objet à motif structuré tel que revendiqué selon la revendication 1, **caractérisé par**:
une étape de formation du motif avec l'encre qui contient les grains constitués des nanoparticules sur un moule;
une étape de formation de l'élément de support avec un matériau fluide de sorte que le motif soit recouvert de l'élément de support; et
une étape de formation de l'agrégat de grains par croissance des grains par chauffage et fusion des nanograins et simultanément durcissement de l'élément de support, et ensuite sortie de l'objet à motif structuré du moule après refroidissement.

12. Procédé de fabrication tel que revendiqué selon l'une quelconque des revendications 10 et 11, **caractérisé en ce qu'**un composant fonctionnel est formé sur le motif en un seul ensemble.

13. Procédé de fabrication tel que revendiqué selon l'une quelconque des revendications 10 et 11, **caractérisé en ce que** le câblage est formé conjointement au motif.
